# EUROPEAN PATENT APPLICATION

(11) **EP 2 154 461 A1**
(43) Date of publication of application: **17.02.2010**
(21) Application number: 08748456.4
(22) Date of filing: 05.05.2008
(51) Int. Cl.: F28D 15/02, H05K 7/20

(54) **UNIFORM TEMPERATURE LOOP HEAT PIPE DEVICE**

(30) Priority: 16.05.2007 CN 200710028044
(71) Applicant: Sun Yat-Sen University, Guangdong 510275 (CN)
(72) Inventor: LU, Shu-Shen, Guangzhou Guangdong 510275 (CN); CHIN, Chi-Te, Guangzhou Guangdong 510275 (CN)
(74) Representative: Mohun, Stephen John
(86) International application number: PCT/CN2008/000898
(87) International publication number: WO 2008/138216

(57) **Abstract**

This invention declares a heat transfer device combined a flatten loop heat pipe with a vapor chamber, in which the loop heat pipe has an evaporator and a condenser, and the vapor chamber is on the evaporation part of the loop heat pipe evaporator. Metal mesh is coating on the inside surface of the vapor chamber, and coating a metal plate with vent holes on it and with supports on the both side. Working fluid is filled into the vapor chamber. Besides the advanced heat transfer characteristics of the flatten loop heat pipe, this invention has an additional advantage from the vapor chamber, which could spread the high heat flux hot spot on the chips quickly to reduce the temperature of the chips and give the chips an advantage of higher density of integration and higher running speed. Based on the combination of the loop heat pipe and the vapor chamber, changing the cooling method, using both the temperature control fins and the condenser fins, this new device could increase the temperature control accuracy and the flexibility.

## Description

### TECHNICAL AREA

The present invention relates to the general heat transfer and electronic cooling field, and more particularly to a heat transfer device combined a flatten loop heat pipe and a vapor chamber.

### BACKGROUND

Loop heat pipe is a new type of two-phase high efficient heat transfer device, which is driven by the capillary force from the wick material, and inside which the heat is transferred by phase change, therefore the loop heat pipe can transfer large heat from a long distance with small temperature difference.

The evaporator of the loop heat pipe locates on the heat source, and with a primary wick inside it. The compensation chamber is connected with the evaporator by a secondary wick. The condenser is attached on a heat sink. The evaporator and the condenser pipe are connected by the vapor pipe, and the condenser pipe and the compensation chamber are connected by the liquid pipe. When the evaporator is heated, the liquid in the primary wick absorbs heat and becomes vapor, then the vapor transports to the condenser pipe via the vapor pipe, and condense to the liquid in the condenser to release the heat, finally the liquid flows into the compensation chamber and the wick part.

For the common loop heat pipe, the wick will dry out when the mass flow rate of evaporation is larger than that of returning. Besides, the large thermal conductivity of the wick leads to the large heat leak from the evaporator to the compensation chamber, results in high temperature in the compensation chamber and then high operation temperature of the loop heat pipe.

A Chinese patent named High Efficient Flatten Loop Heat Pipe (No. 200510035406.4) reveals a flatten loop heat pipe, which comprising two wicks, the primary wick for evaporation and the secondary wick for compensation. The primary wick consists horizontal and vertical grooves, which are advanced for evaporation, and the vapor can flow via the grooves with a lower pressure drop, leads to a lower total pressure drop of the loop and a better performance of the loop.

Anyway, the loop heat pipes applied in high heat flux chips doesn't show perfect effect at its present status.

### CONTENTS OF THE INVENTION

The purpose of this invention is to overcome the disadvantages of the existing loop heat pipes, and invent a new device combined a flatten loop heat pipe and a vapor chamber for high heat flux chips cooling.

To achieve this purpose, this invention follows these technical designations:
A heat transfer device combined a flatten loop heat pipe with a vapor chamber, in which the loop heat pipe has an evaporator and a condenser, and the vapor chamber is on the evaporation part of the loop heat pipe. Mesh material is coating on the inside surface of the vapor chamber, and coating a metal plate with vent holes on it and with supports on the both side. The metal plate with vent holes can be replaced by metal mesh. Working fluid is filled into the vapor chamber.

To control the system temperature, temperature control fins can be located into the heat transfer device combined a flatten loop heat pipe and a vapor chamber.

To increase the cooling effects, the condenser of the heat transfer device combined a flatten loop heat pipe and a vapor chamber can comprise a condensing clip ring and condensing fins, where the condensing fins locate on the outside surface of the condensing clip ring.

To increase the cooling effects, the condenser of the heat transfer device combined a flatten loop heat pipe and a vapor chamber can comprise a condensing clip pate and condensing fins, where the condensing fins locate on the outside surface of the condensing clip plate which can be one-side or double-side clip plate.

To increase the flexibility and the accuracy of the temperature control, the condensing clip pate in such a heat transfer device combine a flatten loop heat pipe and a vapor chamber can be extended to the whole device, and both the temperature control fins and the condensing fins locate on the other side of the condensing clip plate.

Compared with the exiting technology, the present invention has the following advantages.
(1) The improvement in heat transfer capability is obviously. Besides the advanced heat transfer performance of the loop heat pipes, the present invention has an additional advantage from the vapor chamber, which could spread the high heat flux hot spot on the chips quickly to reduce the temperature of the chips and give the chips an advantage with higher density of integration and higher running speed.
(2) The improvement in the flexibility and the accuracy of the temperature control is obviously. Based on the combination of the loop heat pipe and the vapor chamber, changing the cooling method by using both the temperature control fins and the condensing fins could increase the temperature control accuracy and the flexibility.

### DESCRIPTION OF THE DRAWINGS

Fig.1 is the structural sketch of the heat transfer device combined a flatten loop heat pipe and a vapor chamber
Fig.2 is the structural sketch of the clip ring condenser
Fig.3 is the structural sketch of the clip plate condenser
Fig.4 is the structural sketch of such heat transfer device with both the condensing fins and the temperature control fins

### DETAILED EXECUTIONS

### Example 1

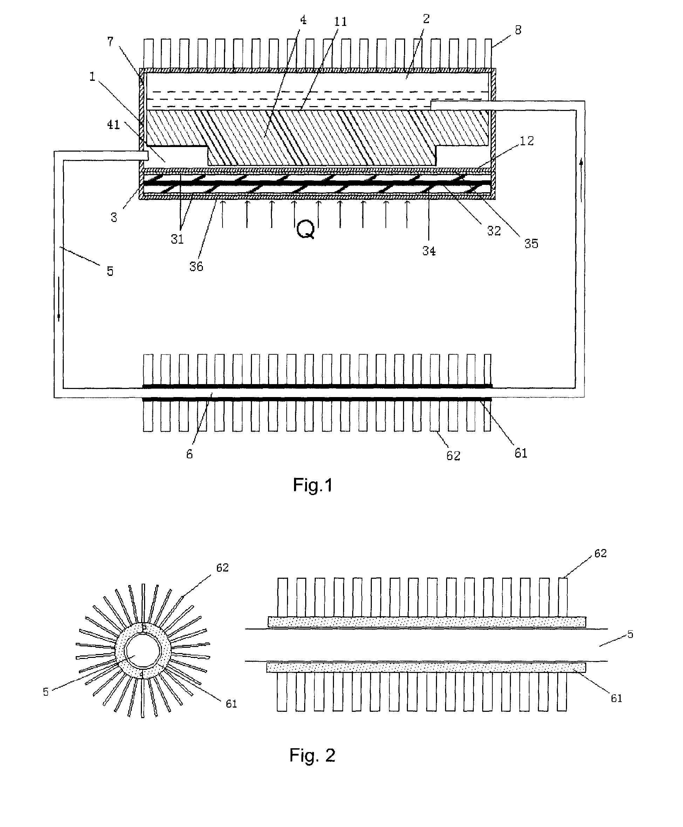

As shown in Fig.1, a heat transfer device combined a flatten loop heat pipe and a vapor camber, comprises an evaporator (1), a compensation chamber (2) and a vapor chamber(3); both the evaporator (1) and the compensation chamber (2) are in the same container (7); the cold side (11) of the evaporator (1) is connect to the compensation chamber(2), and the hot side(12) of the evaporator (1) is connect to the condensing side (35) of the vapor chamber(3); the wick (4) is installed in the evaporator (1); the bottom of the wick (4) and the evaporator (1) form the vapor grooves (41); the vapor grooves (41) is connected to the transport pipe(5), and condenser locates on the outside surface of the transport pipe (5), the returning part of the transport pipe (5) is connected to the compensation chamber (2); the metal mesh (31) is attached on the inside surface of the vapor chamber (3); the metal mesh coats a metal plate (32) with vent holes, and with supports on the both sides(34); both of the compensation chamber (2) and the vapor chamber (3) are filled with working fluid. The outside surface of the container (7) has the temperature control fins (8). The bottom of the wick (4) has both horizontal and vertical grooves. The metal mesh (31) is larger than 100mesh. The condenser (6) comprises condensing clip ring (61) and condensing fins (62), and the condensing fins (62) locate on the outside surface of the condensing clip rings (61), as shown in Fig.2.

During the operation, the evaporation part (36) of the vapor chamber (3) is attached on the heat load Q (chips), and the working fluid inside the vapor chamber (3) will evaporate, then the saturated vapor will go through the vent holes in the metal plate(32) and transfer the heat to the condense part (35) to condense into the liquid, which will attached on the metal mesh (31), and then flows back to the bottom of the evaporation part (36) of the vapor chamber (3) driven by the capillary force from the metal mesh (31).

For the evaporator (1), its evaporation part (12) is connect with the condensation part (35) of the vapor chamber (3), and the wick (44) is inside the evaporator (1). When the evaporator (1) is heated by the vapor chamber (3), the liquid in the wick (4) will evaporate, and the vapor flows through the grooves (41) to the transfer pipe (5), then condense in the condenser (6) to become the liquid again, and finally back to the compensation chamber (2) and the wick (4).

### Example 2, Flexible heat transfer modular

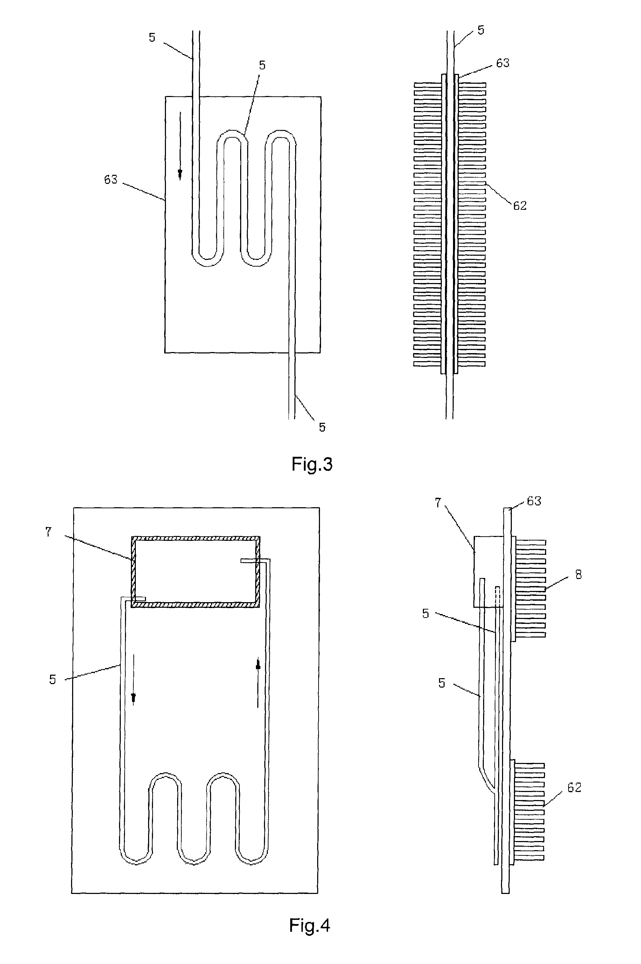

Fig.3 is the structural sketch of the clip plate condenser. The condenser (6) comprises a condensing clip plate (63) and condensing fins (62), and the condensing fins (62) locate on the outside surface of the condensing clip plate (63) which can be one-side or double-side clip plate.

Fig.4 is the structural sketch of such a heat transfer device with both the condensing fins and the temperature control fins. In order to improve the flexibility and the accuracy of the temperature control, the condensing clip plate (63) is extended to the whole device, and both the temperature control fins (8) and the condensing fins (62) locate on the other side of the condensing clip plate (63).

## Claims

1. A heat transfer device combined a flatten loop heat pipe with a vapor chamber, in which the loop heat pipe has an evaporator (1) and a condenser (2), and the vapor chamber (3) is on the evaporation part (12) of the loop heat pipe evaporator (1); metal mesh (31) is coating on the inside surface of the vapor chamber (3), and coating a metal plate (32) with vent holes on it and with supports (34) on the both side; working fluid is filled into the vapor chamber (3).

2. One characteristic of the heat transfer device recited in claim 1 is that there installing the temperature control fins (8).

3. One characteristic of the heat transfer device recited in claim 1 or claim2 is that the condenser (6) comprises condensing clip ring (61) and condense fins (62), and the condensing fins (62) locate on the outside surface of the condensing clip ring (61).

4. One characteristic of the heat transfer device recited in claim 1 or claim 2 is that the condenser (6) comprises condensing clip plate (63) and condensing fins (62), and the condensing fins (62) locate on the outside surface of the condensing clip plate (63) which can be one-side or double-side clip plate.

5. One characteristic of the heat transfer device recited in claim 4 is that the condensing clip plate (63) is extended to the whole device, and both the temperature control fins (8) and condensing fins (62) locate on the other side of the condensing clip plates (63).
